# EUROPÄISCHE PATENTSCHRIFT

(11) **EP 1 864 324 B1**
(45) Veröffentlichungstag und Bekanntmachung des Hinweises auf die Patenterteilung: **12.06.2019**
(21) Anmeldenummer: 06707427.8
(22) Anmeldetag: 04.03.2006
(51) Int. Cl.: H01L 23/34, H01L 23/373, H05K 1/02, H01L 23/62, H05K 3/00, H01L 23/40

(54) **VORRICHTUNG UND VERFAHREN ZUR BESTIMMUNG DER TEMPERATUR EINES KÜHLKÖRPERS**
DEVICE AND METHOD FOR DETERMINING THE TEMPERATURE OF A HEAT SINK
DISPOSITIF ET PROCÉDÉ POUR DÉTERMINER LA TEMPÉRATURE D'UN DISSIPATEUR DE CHALEUR

(30) Priorität: 22.03.2005 DE 102005013762
(43) Veröffentlichungstag der Anmeldung: 12.12.2007
(73) Patentinhaber: SEW-EURODRIVE GmbH & Co. KG, 76646 Bruchsal (DE)
(72) Erfinder: PRAUTZSCH, Harald, 73479 Ellwangen (DE)
(86) Internationale Anmeldenummer: PCT/EP2006/002006
(87) Internationale Veröffentlichungsnummer: WO 2006/099936

(56) Entgegenhaltungen:
- EP-A- 1 455 391
- EP-A2- 1 498 947
- US-A- 5 522 215
- US-A- 5 831 333
- US-A1- 2002 005 272
- US-A1- 2002 157 821
- US-A1- 2002 162 678
- US-B1- 6 787 896

## Beschreibung

Die Erfindung betrifft eine Vorrichtung und ein elektronisches Gerät, beispielsweise zur Temperaturüberwachung oder -bestimmung, und ein Verfahren zur Bestimmung, Überwachung und/oder Aufzeichnung der Temperatur eines Kühlkörpers und einer Wärmequelle.

Derartige Wärmequellen treten beispielsweise in Leistungshalbleitern, Kühlkreisläufen, Verbrennungskammern und Reaktionskammern auf.

Aus der EP 0 654 176 ist eine Befestigungsvorrichtung für Halbleiter-Schaltelemente bekannt, bei der auf einer Leiterplatte angebrachte Halbleiter-Schaltelemente an einen Kühlkörper angedrückt werden.

Aus der DE 692 09 772 ist eine Gehäuseanordnung für ein funktionales Bauelement bekannt, wobei eine elektronische Schaltung in einem Hohlraum angeordnet ist und dieser Hohlraum mit einem elektrisch isolierenden Fluid befüllt ist.

Aus der DE 198 07 718 ist eine Elektronikbaugruppe bekannt, bei der ein Niederhalter auf einen Schaltungsträger greift und der Niederhalter einen Anschlusskontakt in einer Durchgangsöffnung eines Gehäuses aufweist, der mit den Leiterbahnen des Schaltungsträgers verbunden ist.

Aus der DE 199 20 401 ist eine Anordnung und ein Verfahren zur Temperaturschätzung bekannt, bei der durch Messung der Temperaturen zweier Sensoren die Temperatur einer elektronischen Einrichtung bereitgestellt wird.

Aus dem Internet-Auftritt vom 16.03.2005 der Firma Quick-Ohm Küpper & Co. GmbH, Wuppertal/Deutschland, sind Wärmeleitkleber bekannt, deren Wärmeleitfähigkeit 7,5 W/mK und mehr beträgt. Aus dem Internet-Auftritt vom 25.12.2003 der Firma Quick-Ohm Küpper & Co. GmbH sind Wärmeleitfolien bekannt, die aus Kohlefaser-Verbundwerkstoff bestehen.

Aus dem Datenblatt der Fa. Philips Semiconductors, Eindhoven/Niederlande zu der Reihe "KTY82-1" vom 26. März 1998 sind Silizium-Temperatur-Sensoren bekannt, die einen positiven Temperatur-Widerstandskoeffizienten aufweisen und die in Mess- und Steuerungssystemen einsetzbar sind.

Aus der US 5 831 333 A sind eine Anordnung und ein Verfahren zur Steuerung der Kontaktstellentemperatur eines Halbleiterchips in einem elektronischen System bekannt, bei welchem eine Temperaturfühleinrichtung in derselben Abdeckung wie der Halbleiterchip angeordnet ist, wodurch die Temperatur der Temperaturfühleinrichtung der tatsächlichen Kontaktstellentemperatur sehr gut entspricht.

Aus der EP 1 498 947 A2 ist eine elektronische Schaltung mit einem Leistungshalbleiterbauelement und mit einem Sicherungsmittel zum Schutz des Leistungshalbleiterbauelements vor Überhitzung bekannt, bei welchem ein Leistungshalbleiterbauelement mit einer metallischen Gehäusefläche an einem Kühlkörper wärmeleitend angebracht ist, wobei ein Halbleiterbaulement mit einem Sicherungsmittel an einer ersten Außenfläche eines Schaltungsträgers wärmeleitend angebracht ist und der Kühlkörper an einer zweiten Außenfläche eines Schaltungsträgers aufgebracht ist, wobei die Außenflächen wärmeleitend verbunden sind. Der Schaltungsträger weist keine Innenlagen auf.

Aus der EP 1 455 391 A1 ist ein Leistungshalbleitermodul mit Sensorikbauteil bekannt, wobei ein Sensorikbauteil mit einer Montagefläche direkt auf einer Hauptfläche eines Isolierstoffkörpers angeordnet und mit seiner dem Isolierstoffkörper abgewandten Seite in thermisch leitendem Kontakt mit einem Kühlkörper ist.

Aus der US 6 787 896 B1 ist eine Halbleiterbaugruppe bekannt, bei der ein Mehrlagen-Substrat einen Kern mit einer Kerndicke, eine obere Fläche und eine untere Fläche hat, bei der ein Halbleiterplättchen auf der oberen Fläche des Mehrlagen-Substrats angeordnet ist und bei der ein Wärmespreizer auf der unteren Fläche angeordnet ist, wobei das Substrat eine erste Metallabdeckung, wenigstens eine Durchkontaktierung und eine zweite Metallabdeckung hat, die erste Metallabdeckung unter dem Halbleiterplättchen angeordnet ist und an dieses thermisch gekoppelt ist, die wenigstens eine Durchkontaktierung unterhalb der ersten Metallabdeckung und in dem Kern des Mehrlagen-Substrats angeordnet ist, die zweite Metallabdeckung unter der wenigstens einen Durchkontaktierung angeordnet und an den Wärmespreizer thermisch gekoppelt ist und die wenigstens eine Durchkontaktierung eine Verbindung zwischen Mehrlagen-Substrat und Wärmespreizer schafft, wobei die wenigstens eine Durchkontaktierung eine Länge hat, die im Wesentlichen der Kerndicke entspricht.

Aus der US 20020005272A ist ein Kühlsystem für ein Mehrfachchip-Modul bekannt, bei welchem elektronische Bauteile über flexible Blätter an einen Kühlkörper angebunden sind.

Aus der US 20020157821A1 ist ein thermisches Regelungssystem für mehrere Lasten mit mehreren seriellen Verdunstungseinrichtungen bekannt, bei welchem ein PID-Regler zur Variation des Massenflusses eines Kühlmittels verwendet wird.

Aus der US 5 522 215 A ist eine Vorrichtung zur Waferkühlung bekannt, bei welcher PID-Regler zur Ansteuerung von Peltier-Elementen, die einen Wafer auf eine vorbestimmte Temperatur kühlen, verwendet werden.

Aus der US 2002/0162678 A1 ist ein elektronischer Apparat bekannt, bei welchem die Wärme von einer elektronischen Komponente über direkt unter der elektronischen Komponente ausgebildete, mit Wärmeleitfett gefüllte Durchgangsbohrungen in eine Nullleiterlage eines Subtrats und von dort an die Atmosphäre geleitet wird. Bei einem weiteren Ausführungsbeispiel wird eine herkömliche Schraube verwendet, um ein Gehäuse an einem Substrat zu befestigen.

Der Erfindung liegt die Aufgabe zugrunde, bei einer Vorrichtung oder einem elektronischen Gerät einen Sensor möglichst gut auf das Temperaturniveau eines Kühlkörpers zu bringen.

Erfindungsgemäß wird die Aufgabe bei der Vorrichtung nach den in Anspruch 1, dem elektronischen Gerät nach den in Anspruch 12 und bei dem Verfahren zur Bestimmung der Temperatur einer Wärmequelle, insbesondere eines Leistungshalbleiters, nach den in Anspruch 15 angegebenen Merkmalen gelöst.

Wesentliche Merkmale der Erfindung bei dem elektronischen Gerät sind in Anspruch 12 angegeben. Insbesondere ist vorgesehen, dass es eine mit einem Sensor bestückte Leiterplatte und einen Kühlkörper umfasst, wobei der Sensor mit dem Kühlkörper wärmeleitend verbunden ist.

Von Vorteil ist dabei, dass die Temperatur von Leistungshalbleitern oder anderen Wärmequellen bestimmbar ist und somit die Gefahr der Überhitzung vermeidbar ist. Insbesondere ist also die Sicherheit erhöht. Durch die verbesserte Temperaturbestimmung sind auch die Regeleigenschaften des elektronischen Geräts verbessert.

Erfindungsgemäß ist bei dem elektronischen Gerät die Leiterplatte mit dem Kühlkörper lösbar verbunden. Von Vorteil ist dabei, dass keine weiteren Zwischenelemente notwendig sind.

Erfindungsgemäß ist bei dem elektronischen Gerät die Leiterplatte eine Multilayer-Leiterplatte und somit mehrlagig. Somit sind Durchkontaktierungen zwischen den Leiterbahnen verschiedener Lagen ermöglicht. Auf diese Weise sind elektrische oder thermische vorteilige Verhältnisse erreichbar.

Bei einer vorteilhaften Ausgestaltung sind metallische Bereiche der Innenlagen, welche in räumlicher Nähe zum Sensor vorgesehen sind, elektrisch verbunden mit mindestens einem metallischen Bereich an der dem Kühlkörper zugewandten Oberfläche. Von Vorteil ist dabei, dass eine thermisch gut leitende Verbindung mit dem Kühlkörper hergestellt wird und dass metallische Bereiche eine höhere Wärmeleitfähigkeit als das Leiterplatten-Trägermaterial aufweisen, insbesondere zum Erreichen eines im Wesentlichen dem Kühlkörper gleichenden Temperaturniveaus in denjenigen Bereichen der Innenlagen, die räumlich dem Sensor nahe sind, insbesondere deren Abstand zu den Berührungspunkten der Teile des Sensors mit der Leiterplatte kleiner als die Dicke der Leiterplatte ist. Somit ist der Sensor noch besser an das Temperaturniveau des Kühlkörpers angekoppelt.

Bei einer vorteilhaften Ausgestaltung ist der metallische Bereich an der dem Kühlkörper zugewandten Oberfläche mit dem Kühlkörper elektrisch und/oder zumindest wärmeleitend verbunden. Von Vorteil ist dabei, dass beispielsweise Wärmeleitpaste verwendbar ist zur Verbesserung des Wärmeübergangs. Aber auch direkter Kontakt ist schon ausreichend wärmeleitend. Auf diese Weise wird nicht nur das elektrische Potential angeglichen sondern auch die Temperatur. Die Wärme des Kühlkörpers ist also in die Leiterplatte hineinleitbar - ähnlich wie elektrischer Strom auf den Leiterbahnen fließt die Wärme dabei bevorzugt auf den metallischen Leiterbahnen.

Bei einer vorteilhaften Ausgestaltung wird zur Verbindung ein Befestigungselement verwendet. Von Vorteil ist dabei, dass ein kostengünstiges Element, wie eine Schraube oder dergleichen verwendbar ist.

Bei einer vorteilhaften Ausgestaltung umfassen die elektrischen Verbindungen Durchkontaktierungen. Insbesondere sind Anschlusselemente des Sensors an der dem Kühlkörper zugewandten Oberfläche mittels Lötverbindung elektrisch verbunden, wobei mittels Durchkontaktierung die Anschlusselemente des Sensors mit Leiterbahnen der dem Kühlkörper abgewandten Oberflächen oder mit Innenlagen der Leiterplatte verbunden sind. Von Vorteil ist dabei, dass die Sensorsignale auf kurzen Wegen abgeleitet werden in andere Leiterbahnen, die große Kriechstrecken zum Potential des Kühlkörpers ausweisen. Aber auch die Wärme des Kühlkörpers ist in einfacher Weise in Innenlagen transportierbar, inbesondere zur Herstellung eines homogenen Temperaturniveaus in den Innenlagen der Leiterplatte.

Bei einer vorteilhaften Ausgestaltung sind die Lötverbindungen mittels SMD-Technik ausgeführt. Von Vorteil ist dabei, dass Massenproduktion vorsehbar ist.

Bei einer vorteilhaften Ausgestaltung umfassen die metallischen Bereiche Kupfer oder bestehen im Wesentlichen aus Kupfer, insbesondere sind sie Leiterbahnen der Leiterplatte. Von Vorteil ist dabei, dass hohe elektrische und thermische Leitfähigkeit durch ein einziges Material realisierbar ist.

Bei einer vorteilhaften Ausgestaltung ist der Kühlkörper mit Kühlflächen von Leistungshalbleitern wärmeleitend verbunden, insbesondere entweder direkt oder indirekt, mittelbar oder unmittelbar über mindestens eine Keramikplatte oder andere thermisch leitfähige Materialien, beispielsweise Wärmeleitfolie. Von Vorteil ist dabei, dass eine hohe Wärmeleitfähigkeit zur Ableitung der Wärme der Leistungshalbleiter an den Kühlkörper vorhanden ist, aber auch ein hoher Isolationsabstand zwischen Kühlkörper und den Leistungshalbleitern realisierbar ist.

Wesentliche Merkmale der Erfindung bei dem Verfahren zur Bestimmung der Temperatur einer Wärmequelle, insbesondere eines Leistungshalbleiters, sind in Anspruch 15 angegeben. Insbesondere ist vorgesehen, dass die Wärmequelle mit einem Kühlkörper wärmeleitend verbunden ist und der Sensor mit dem Kühlkörper wärmeleitend verbunden ist, wobei
- die Temperatur des Sensors bestimmt wird,
- ein Maß für den Temperaturanstieg innerhalb einer Zeitspanne bestimmt wird,
- aus der Summe der Temperatur des Sensors und dem mit einem zum Temperaturanstieg zugehörigen Korrekturfaktor multiplizierten Maß die Temperatur der Wärmequelle bestimmt wird.

Von Vorteil ist dabei, dass das Verfahren sehr einfach auszuführen, insbesondere zu programmieren ist und nur geringste Mengen an Speicher-Ressourcen und Rechnerleistung benötigt.

Bei einer vorteilhaften Ausgestaltung wird das Maß für den Temperaturanstieg innerhalb einer Zeitspanne dadurch bestimmt, dass die Differenz der neuesten und der davor zuletzt gemessenen Temperatur des Sensors bestimmt wird, wobei die Zeitspanne zwischen den Messungen der Temperatur des Sensors stets gleich oder im Wesentlichen gleich ist. Bei einer entsprechenden Ausgestaltung wird das Maß für den Temperaturanstieg innerhalb einer Zeitspanne dadurch bestimmt, dass die Steigung des zeitlichen Verlaufs der Temperatur des Sensors bestimmt wird, also die erste zeitliche Ableitung. Von Vorteil ist dabei, dass die Art und Weise der Temperaturfindung einfach und schnell funktioniert und trotzdem bei vielen Technischen Anwendungsfällen ein genügend gutes Resultat herbeiführt.

Insbesondere wird bei einer weiteren vorteilhaften Ausgestaltung statt des Korrekturfaktors eine Tabelle von Korrekturfaktoren verwendet, wobei jedem Steigungswert und/oder jedem Umgebungstemperatur-Wert und/oder anderen Größen ein Korrekturfaktor zugeordnet ist und entsprechend verwendet wird. Von Vorteil ist dabei, dass das genannte Verfahren weiter verbesserbar ist.

Bei einer weiteren vorteilhaften Ausgestaltung wird in dem Verfahren von einem Umrichter die erfasste Temperatur zur Regelung bei der Versorgung eines Elektromotors verwendet und/oder aufgezeichnet.

Bei einer weiteren vorteilhaften Ausgestaltung wird in dem Verfahren bei Überschreitung eines vorgegebenen Grenzwerts der mit dem Sensor erfassten Temperatur
- die Pulsweitenmodulationsfrequenz und/oder Leistungszufuhr des Umrichters reduziert,
- der Umrichter abgeschaltet
- und/oder ein Warnsignal an den Bediener der Anlage gesendet.

Weitere Vorteile ergeben sich aus den Unteransprüchen.

Die Erfindung wird nun anhand von Abbildungen näher erläutert. Dabei zeigt:
Fig. 1 eine erfindungsgemäße Vorrichtung in Schnittansicht,
Fig. 2 eine weitere erfindungsgemäße Vorrichtung in Schnittansicht,
Fig. 3 eine dritte erfindungsgemäße Vorrichtung in Schnittansicht,
Fig. 4a eine vierte erfindungsgemäße Vorrichtung in Draufsicht,
Fig. 4b eine Innenlage einer Multilayer-Leiterplatte der vierten erfindungsgemäßen Vorrrichtung in Draufsicht.

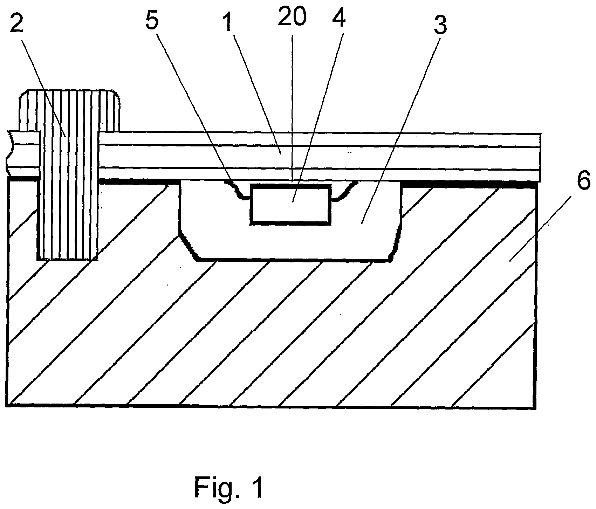

Bei der erfindungsgemäßen Vorrichtung nach Fig. 1 ist die Leiterplatte 1 als Multilayer-Leiterplatte ausgeführt und umfasst daher mehrere Ebenen, in welchen Kupferbahnen vorgesehen werden können.

Die Leiterplatte 1 ist mit einer Schraube als Befestigungsmittel 2 zur lösbaren Verbindung mit dem Kühlkörper 6 verbunden.

Auf der dem Kühlkörper zugewandten Seite der Leiterplatte 1 ist ein Sensor 4 mit seinen Anschluss-Füßchen 5 angelötet. Dies ist vorteiligerweise in SMD-Technik ausgeführt. Von diesen Lötkontakten wird eine elektrische Verbindung in Form einer Durchkontaktierung durch alle Lagen der Leiterplatte 1 hindurch vorgesehen zur Verbindung mit Leiterbahnen auf der Oberseite der Leiterplatte 1. Somit werden auch die Messsignale des Sensors über diese Durchkontaktierungen auf die Oberseite der Leiterplatte 1 weitergereicht, wodurch zwischen Signalleitungen und dem elektrisch leitfähigen Kühlkörper genügend Isolationsabstand vorgebbar ist.

Auf diese Weise ist es auch ermöglicht, Leiterbahnen in anderen Ebenen, insbesondere Innenlagen der Multilayer-Leiterplatte 1, oberhalb des Sensors elektrisch und daher auch thermisch zu verbinden mit Kupferbereichen an der Unterseite der Leiterplatte, die in direkten Kontakt bringbar sind mit dem Kühlkörper. Dadurch wird erreicht, dass auch über die Innenlagen der Leiterplatte das Temperaturniveau des Kühlkörpers an den Sensor weitergegeben wird. Der Sensor ist sozusagen umgeben oder eingebettet in das Temperaturniveau des Kühlkörpers, obwohl der Kühlkörper selbst ihn nicht ganz umgibt.

Zur thermischen Verbindung dient insbesondere auch das Befestigungsmittel 2, welches die Leiterplatte 1 und somit auch die genannten Kupferbereiche an der Unterseite der Leiterplatte an den Kühlkörper 6 andrückt.

Darüber hinaus dient das Befestigungsmittel 2 der mechanischen Verbindung der Leiterplatte 1 mit dem Kühlkörper 6. Somit erfolgt die Verbindung von Leiterplatte und Kühlkörper mittels eines Befestigungselementes zur lösbaren Verbindung des Kühlkörpers mit der Leiterplatte, beispielsweise mit einer Schraube.

Der Sensor 4 ist in einer Ausnehmung des Kühlkörpers 6 angeordnet, die mit Wärmeleitpaste 3 ausgefüllt ist. Die Befüllung ist vorteiligerweise vor der Montage des Sensors 4 ausführbar.

Die Ausnehmung ist derart ausgeführt und dimensioniert, dass erforderliche Luft- und Kriechstrecken zum Sensor und dessen Anschlüssen eingehalten sind.

Die Leiterplatte 1 ist darüber hinaus in Bereichen, die nicht in Figur 1 zu sehen sind, mit Leistungshalbleitern, wie beispielsweise IGBT, bestückt, deren Kühlflächen mit dem Kühlkörper 6 wärmeleitend verbunden sind. Dazu können die Kühlflächen direkt an den Kühlkörper verbunden sein oder indirekt über eine Keramikplatte.

Vorteiligerweise ist der Sensor 4 als Temperatursensor ausgeführt zur Überwachung der Temperatur der Leistungshalbleiter. Durch diese Temperaturerfassung wird eine genaue Regelung der Leistungshalbleiter besser ermöglicht.

Hauptsächlich ist der Sensor thermisch gut leitend an den Kühlkörper 6 angekoppelt, also mit einem geringen Wärmeübergangswiderstand. Der Kühlkörper ist direkt oder indirekt gut wärmeleitend mit den Kühlflächen der Leistungshalbleiter verbunden. Der Sensor 4 ist in räumlicher Nähe zu den Leistungshalbleitern angeordnet. Somit benötigt die von den Leistungshalbleitern über den Kühlkörper fließende Wärme nur geringe Zeitspannen. Der Temperaturverlauf am Sensor folgt den Temperaturen im Inneren der Leistungshalbleiter oder den Temperaturen der Kühlflächen der Leistungshalbleiter mit einer Verzögerungszeit von einigen Sekunden. Vorteiligerweise ist die Anordnung derart ausgelegt, dass die Verzögerungszeit zwischen einer Sekunde und einer Minute oder 3 Minuten liegt. Nach dieser Verzögerungszeit erreicht die Temperatur des Sensors im Rahmen der Messgenauigkeit den stationären Wert, wenn eine konstante Verlustleistung am Leistungshalbleiter vorgegeben wird.

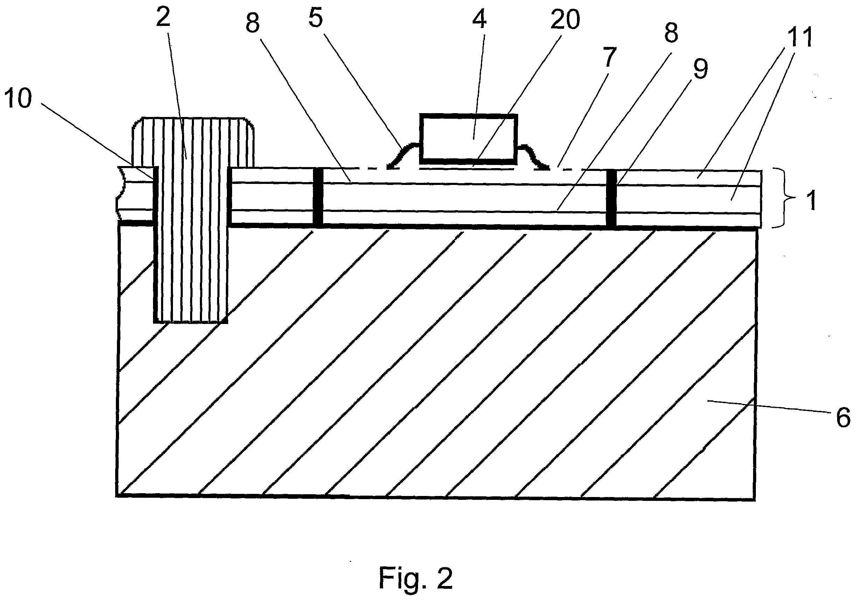

Bei dem in Fig. 2 dargestellten Ausführungsbeispiel ist eine Leiterplatte 1 mit einem Kühlkörper 6 verbunden. Diese Verbindung wird über eine Schraube 2 hergestellt.

An der Leiterplatte 1 auf der vom Kühlkörper 6 abgewandten Seite ist ein Sensor 4 angebracht.

Die Leiterplatte 1 umfasst als Multilayer-Leiterplatte metallische Bereiche in Innenlagen, die Innenbahnen 8, die aufgrund ihrer hohen Wärmeleitfähigkeit die Temperatur eines Kühlkörpers 6 in die Leiterplatte 1 und insbesondere in die räumliche Nähe des Sensors 4 vermitteln. Hierbei ist die Wärmeleitfähigkeit der Innenbahnen 8 deutlich höher als die des Trägermaterials 11 der Multilayer-Leiterplatte. Die Verwendung von metallischen Materialien, wie Kupfer oder Kupfer-Legierungen, für die Innenbahnen sowie von Kunststoffen, wie Epoxidharz, für das Trägermaterial der Multilayer-Leiterplatte ist vorteilhaft.

Unter der räumlicher Nähe des Sensors wird hier die Menge aller Raumpunkte verstanden, deren räumlicher Abstand zum Sensor 4, umfassend seine Anschluss-Füßchen 5 oder Anschlussvorrichtungen, kleiner als die Dicke der Leiterplatte 1 ist.

Zur Bewirkung der thermischen Anbindung wird zwischen Kühlkörper 6 und Innnenbahnen 8 zumindest auch die Schraube 2 verwendet. Von Vorteil ist dabei, dass die Bohrung 10 für die Schraube 2 nach der Art einer Durchkontaktierung mit einem elektrischen Leiter ausgekleidet ist, wodurch die thermische Anbindung der Innenbahnen 8 an die Schraube 2 und damit an den Kühlkörper 6 verbessert ist. Von Vorteil ist weiterhin, dass auf der dem Schraubenkopf zugewandten Seite der Leiterplatte metallische Flächen angeordnet sind, die einen guten thermischen Kontakt zu den Innenlagen der Leiterplatte herstellen.

Zur Bewirkung der thermischen Anbindung zwischen Kühlkörper 6 und Innenbahnen 8 sind weiterhin in den Bereichen des Leiterplatte 1, die den Kühlkörper 6 berühren, an der Oberfläche der Leiterplatte metallische Bereiche vorgesehen, die zumindest über die metallisch ausgekleidete Bohrung 10 elektrisch und wärmeleitend mit den Innenbahnen 8 verbunden sind. Dadurch wird ein sehr großer Wärmeübergangskoeffizient für den Wärmeübergang zwischen Kühlkörper 6 und Innenbahnen 8 erreicht.

Die hohe Wärmeleitfähigkeit der Innenbahnen 8 bewirkt, dass die vermittelte Temperatur in der Nähe des Sensors 4 im Wesentlichen der Temperatur des Kühlkörpers 6 gleicht. Wegen der geringen Wärmekapazität der Innenbahnen 8 folgt die Temperatur auch den Änderungen der Temperatur des Kühlkörpers.

Die Genauigkeit der Gleichheit dieser beiden Temperaturen hängt von den genauen physikalischen Eigenschaften der thermischen Anbindung der Innenbahnen 8 an den Kühlkörper 6 und ihren genauen Wärmekapazitäten ab. Die geometrische Ausführung der Innenlagen und der mechnischen Anbindung der Leiterplatte an den Kühlkörper ist also dabei so gewählt, dass die jeweilige Wärmekapazität und der Wärmeübergangswiderstand vom Kühlkörper 6 zum Sensor 4 klein ist.

Dabei erfolgt die Wärmeleitung zu dem Temperatursensor 4 zumindest über die Anschluss-Füßchen 5 und die daran anschließenden Leitungen in den Sensor 4.

Die in Figur 2 schematisch dargestellten Innenbahnen 8 umfassen zwei Lagen von Leiterbahnen. Von Vorteil ist dabei, dass die thermische Anbindung verbessert ist.

Die Innenbahnen 8 der Leiterplatte 1 sind verbunden mit Durchkontaktierungen 9. Somit sind verschiedene Innenbahnen 8 untereinander und/oder mit metallischen Oberflächen der Leiterplatte 1 elektrisch und thermisch verbunden, wodurch die Innenbahnen 8 auf verbesserte Weise die Temperatur des Kühlkörpers 6 in die Nähe des Sensors 4 vermitteln können. Insbesondere ist vorteiligerweise eine homogene Temperaturverteilung erreichbar.

Auf der dem Sensor 4 zugewandten Oberfläche der Leiterplatte 1 sind Strukturen, umfassend Isolierbereiche 7 und elektrische Leiterbahnen, vorgesehen, mittels derer der Sensor 4 über Anschluss-Füßchen 5 elektrisch an eine nicht gezeigte Auswerteeinheit angeschlossen ist. Diese Leiterbahnen sind dabei so geführt, dass ein hinreichender elektrischer Isolier-Abstand, insbesondere gemäß der Norm
EN 61800-5-1, zu denjenigen metallischen Bereichen eingehalten wird, die das elektrische Potential des Kühlkörpers aufweisen. Damit wird vorteilig erreicht, dass der Sensor 4 auf einem von dem des Kühlkörpers verschiedenen elektrischen Potential betrieben werden kann. Insbesondere kann deshalb der Sensor ohne aufwendige galvanische Entkoppelungs-Anordnungen in einen nicht gezeigten Schaltungskreis eingebunden werden.

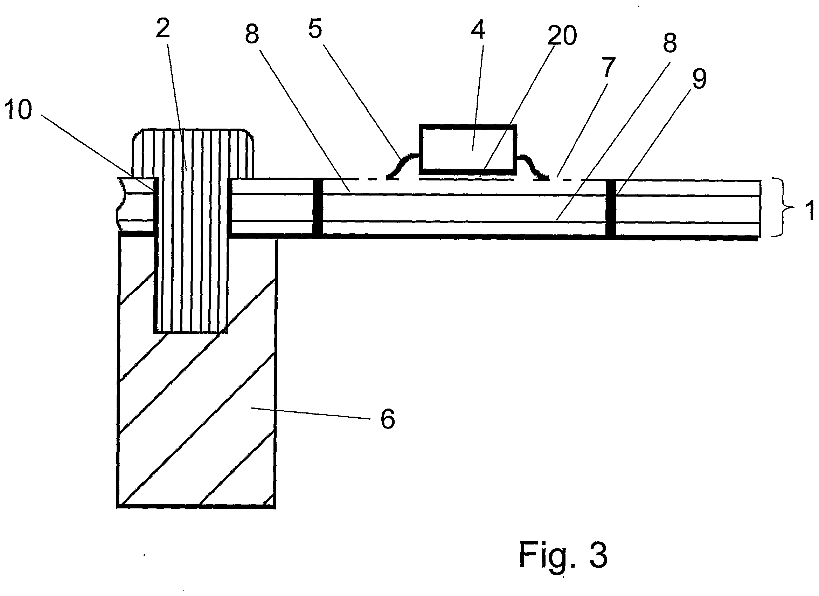

Bei dem in Figur 3 gezeigten erfindungsgemäßen Ausführungsbeispiel erstreckt sich die Auflagefläche des Kühlkörpers 6 auf der Leiterplatte 1 nicht in diejenigen Bereiche, die dem Sensor 4 auf der ihm abgewandten Seite der Leiterplatte 1 gegenüber liegen. Der Sensor 4 ist mithin in einem Bereich der Leiterplatte montiert, dessen räumlicher Abstand von der Berührungsfläche von Kühlkörper und Leiterplatte ein eins übersteigendes Vielfaches der Länge des Sensors 4 beträgt. Von Vorteil ist dabei, dass der Sensor 4 flexibel platzierbar ist und dennoch - insbesondere über Innenbahnen 8 - eine sehr gute thermische Anbindung des Sensors 4 an das Temperaturniveau des Kühlkörpers möglich ist. Je nach Anforderungen an die Qualität der thermischen Anbindung kann der Abstand des Sensors von der Berührungsfläche von Kühlkörper und Leiterplatte ein Zehnfaches der Länge des Sensors deutlich übersteigen.

Ausführungen, bei denen der Sensor 4 in räumlicher Entfernung vom Kühlkörper 6 im Sinne des vorhergehenden Absatzes, jedoch auf der gleichen Seite der Leiterplatte 1 wie der Kühlkörper 6 angeordnet sind, werden von der Erfindung ebenfalls umfasst.

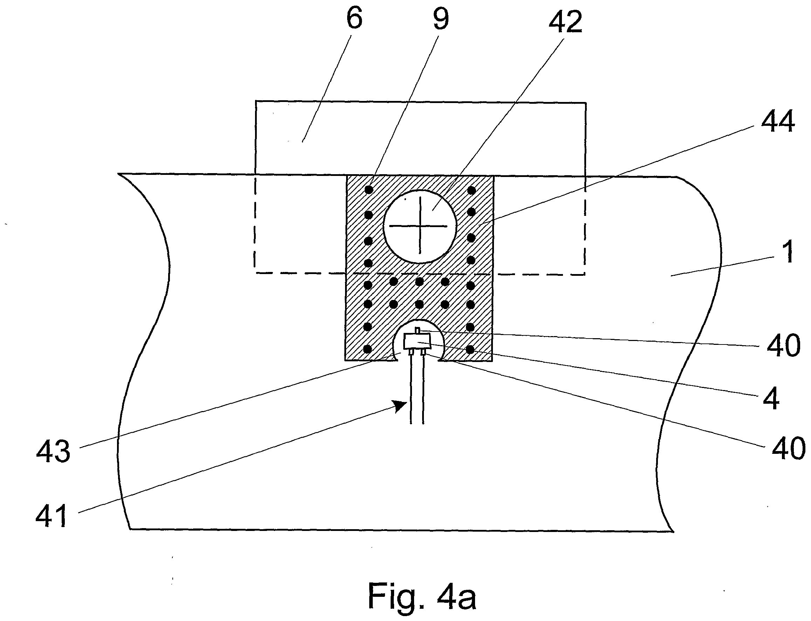

Bei dem in Figur 4a gezeigten erfindungsgemäßen Ausführungsbeispiel ist eine Multilayer-Leiterplatte 1 dargestellt, auf der ein Sensor 4 montiert ist. Dieser Sensor 4 ist über Anschluss-Füßchen 40 mit der Leiterplatte 1 verbunden. Über Anschlussbahnen 41 auf der Leiterplatte 1 ist der Sensor 4 an eine nicht gezeigte Auswerteeinheit angeschlossen.

Als Sensor wird vorzugsweise ein Silizium-Temperatur-Sensor aus der Reihe "KTY82-1" der Fa. Philips Semiconductors verwendet.

Ein Kühlkörper 6 ist über eine nicht gezeigte, durch ein Bohrloch 42 geführte Schraube mit der Leiterplatte 1 verbunden. Die Leiterplatte 1 weist an ihrer dem Kühlkörper abgewandten Oberfläche einen metallischen Bereich 44 auf, der an den Kopf der Schraube elektrisch und also wärmeleitend angeschlossen ist.

Um den Sensor 4 ist ein isolierender Bereich 43 ausgebildet, der eine elektrische Trennung des Sensors 4 von dem elektrischen Potential des Kühlkörpers bewirkt. Insbesondere ist die geometrische Ausgestaltung des isolierenden Bereichs 43 gemäß der Norm EN 61800-5-1 und der Potentialdifferenz zwischen Sensor 4 und Kühlkörper 6 ausgeführt.

Durchkontaktierungen 9 stellen eine elektrische und also auch wärmeleitende Verbindung des metallischen Bereichs 42 zu metallischen Bereichen der Innenlagen, also Innenbahnen, der Leiterplatte 1 her.

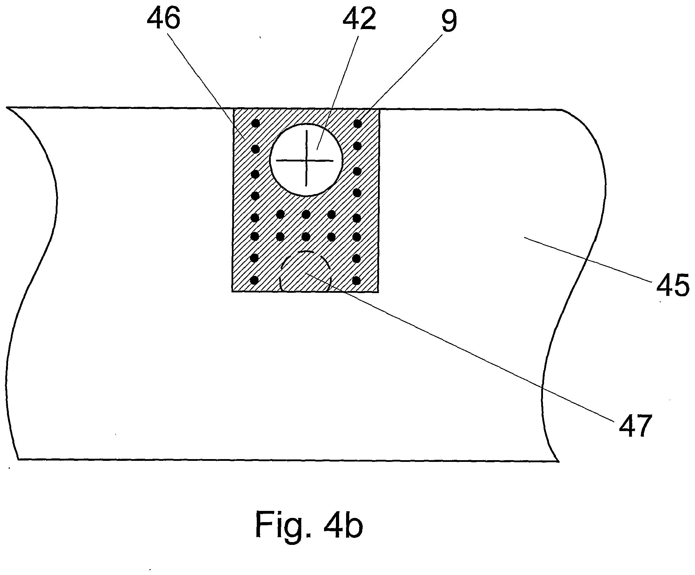

Eine solche Innenlage 45 zeigt Fig. 4b in Draufsicht. Auf ihr sind Innenbahnen 46 vorgesehen, die über Durchkontaktierungen 9 mit den metallischen Bereichen 44 auf der Oberfläche verbunden sind. Diese Innenbahnen 46 erstrecken sich insbesondere auch auf Teilbereiche 47, die in Blickrichtung der Draufsicht unterhalb des Sensors 4 angeordnet sind. Dadurch wird eine sehr gute thermische Anbindung des Sensors 4 an den Kühlkörper 6 bei gleichzeitiger sicherer elektrischer Isolation von Potentialdifferenzen bewirkt.

Durch die Vielzahl der eingesetzten Durchkontaktierungen 9 und die Innenbahnen wird eine sehr gute thermische Anbindung des Sensors 4 an den Kühlkörper erreicht.

Wenn beispielsweise der isolierende Bereich 43 einen Abstand des metallischen Bereichs 44 von ungefähr 3 mm zu den Anschluss-Füßchen 40 des Sensors schafft und wenn die Innenbahnen 46 der Multilayer-Leiterplatte ungefähr 200 µm von der Oberfläche der Leiterplatte entfernt sind, so lassen sich elektrische Potentialdifferenzen von ungefähr 300 V zwischen Sensor 4 und Kühlkörper 6 erreichen bei gleichzeitiger sehr guter thermischer Anbindung zwischen Sensor 4 und Kühlkörper 6.

Bei einem weiteren erfindungsgemäßen Ausführungsbeispiel weist der Kühlkörper Ausnehmungen auf, die Teile der mit dem Sensor verbunden Leiterplatte umschließen. Von Vorteil ist dabei insbesondere, dass der Kühlkörper für die Leiterplatte teilweise eine gehäusebildende Funktion übernimmt und dass der Wärmeübergangswiderstand zwischen Leiterplatte und Kühlkörper besonders gering ist.

Bei einem weiteren erfindungsgemäßen Ausführungsbeispiel ist der Sensor 4 ist über Anschluss-Füßchen (5,40) in SMD-Technik mit der Leiterplatte 1 verbunden.

Bei einem weiteren erfindungsgemäßen Ausführungsbeispiel ist der Sensor 4 ein Halbleiter-Sensor oder ein Platin-Widerstands-Sensor beispielsweise vom Typ pt100 oder pt1000.

Bei einem weiteren erfindungsgemäßen Ausführungsbeispiel ist der Kühlkörper sehr gut wärmeleitend mit mindestens einem Leistungshalbleiter verbunden. Von Vorteil ist dabei, dass mittels des Sensors ein Temperaturmaß für die Temperatur des Leistungshalbleiters bestimmbar ist.

Bei einem weiteren erfindungsgemäßen Ausführungsbeispiel ist der Kühlköper mit Kühlflächen von Leistungshalbleitern entweder mittelbar oder unmittelbar über mindestens eine Keramikplatte wärmeleitend verbunden. Von Vorteil ist dabei, dass einerseits der Kühlkörper elektrisch isoliert ist von den Leitungshalbleitern und andererseits der Wärmeübergang zwischen Leistungshalbleiter und Kühlkörper einen hohe Wärmeübergangskoeffizienten aufweist.

Bei einem weiteren erfindungsgemäßen Ausführungsbeispiel werden anstatt der Schrauben 2 zur Verbindung von Leiterplatte und Kühlkörper andere lösbare oder nicht-lösbare Verbindungen verwendet. Hierbei sind stoffschlüssige Verbindungen, wie beispielsweise Klebeverbindungen, Lötverbindungen oder Schweißverbindungen, und/oder Verbindungen mit Nieten, klemmende und/oder rastende Verbindungen vorteilhaft.

Bei einem weiteren erfindungsgemäßen Ausführungsbeispiel ist der Sensor 4 mit der Leiterplatte 1 zumindest stoffschlüssig verbunden, insbesondere wobei die Verbindung eine Klebeverbindung umfasst, insbesondere wobei die Klebeverbindung zwischen Leiterplatte und Sensor einen niedrigeren Wärmeübergangswiderstand aufweist als eine Verbindung des Sensors mit der Leiterplatte über Anschluss-Füßchen des Sensors. Der Sensor wird somit mittels eines wärmeleitenden Klebers auf der Leiterplatte fixiert. Insbesondere ist dieser Kleber in denjenigen Bereichen aufgetragen, die jeweils den in Fig. 1 bis 3 mit 20 bezeichneten Bereichen entsprechen. Der Kleber weist eine Wärmeleitfähigkeit von 7,5 W/mK oder mehr auf. Beispielsweise kann der Wärmeleitkleber Quick cool der Fa. Quick-Ohm Küpper & Co. Gmbh, Wuppertal/Deutschland verwendet werden. Von Vorteil ist bei diesem Ausführungsbeispiel, dass die thermische Anbindung des Sensors 4 an die Innenbahnen 8 verbessert ist und dass die durch thermische Prozesse bewirkte Materialbelastung der Lötverbindung der Anschluss-Füßchen des Sensors auf der Leiterplatte verringert wird.

Bei weiteren erfindungsgemäßen Ausführungsbeispielen ist das elektronische Gerät ein Fernseher, ein Frequenzumrichter, ein Wechselrichter, ein Stromrichter, eine Lichtorgel, eine Phasenanschnittsteuerung, ein Schaltnetzteil, ein Gleichstromsteller oder allgemein ein Gerät mit Halbleiter-Relais oder Thyristor.

Bei einem weiteren erfindungsgemäßen Ausführungsbeispiel ist statt des Elektrogeräts ein Gerät vorgesesehen, das eine Wärmequelle aufweist, die mit einem Gehäuseteil, beipielsweise einem Kühlkörper, verbunden ist. Dieser Kühlkörper ist mit einer Multilayer-Leiterplatte gemäß dieser Erfindung verbunden. Damit lässt sich auf einfache und robuste Weise die Wärmequelle überwachen.

Bei einem weiteren erfindungsgemäßen Ausführungsbeispiel ist der Kühlkörper ein Teil des Gehäuses eines Verbrennungsmotors oder ist mit diesem sehr gut wärmeleitend verbunden. Von Vorteil ist dabei, dass mittels des Sensors die Temperatur eines Verbrennungsmotors einfach überwachbar ist.

Bei einem weiteren erfindungsgemäßen Ausführungsbeispiel ist der Kühlkörper Bestandteil einer Heizungsanlage. Von Vorteil ist dabei, dass mit dem Sensor 4 die Temperatur von Heizkörpern und/oder Brennkammern der Heizungsanlage bestimmbar und überwachbar ist.

Bei einem weiteren erfindungsgemäßen Ausführungsbeispiel ist der Kühlkörper Bestandteil einer chemischen Anlage zur Durchführung von chemischen Reaktionsprozessen. Von Vorteil ist dabei, dass mit dem Sensor 4 die Temperatur von Behältern der chemischen Anlage und damit die Temperatur der an der chemischen Reaktion beteiligten Stoffe bestimmbar und überwachbar ist.

Bei einem weiteren erfindungsgemäßen Ausführungsbeispiel ist der Kühlkörper Bestandteil eines Kühlkreislaufs, beispielsweise in einem Kraftwerk. Von Vorteil ist dabei, dass sich auf robuste, kostengünstige, leicht zu wartende Weise ein dezentraler Temperatur-Überwachungskreis bilden lässt.

Es hat sich nun herausgestellt, dass die bestimmte Temperatur des Sensors zur Ermittelung der Temperatur des Leistungshalbleiters und/oder des Kühlkörpers in folgender Weise verwendet werden kann:
Vorzugsweise werden die Leistungshalbleiter pulsweitenmoduliert betrieben, insbesondere bei einem elektronischen Gerät, wie Umrichter oder dergleichen.

Aus elektrischen Messgrößen, wie Strom und Spannung, sowie aus den Parametern, die die Pulsweitenmodulation definieren, wird die Verlustleistung der Leistungshalbleiter bestimmt. Als Strom ist insbesondere der Motorstrom des vom Umrichter versorgten Elektromotors vorsehbar. Als Spannung ist beispielsweise die Zwischenkreisspannung des Umrichters vorsehbar. Als Parameter sind beispielsweise das Pulsweitenmodulationsverhältnis zu nennen. Wenn nun weiter die Wärmeübergangswiderstände zwischen Leistungshalbleiter und Sensor sowie zwischen Kühlkörper und Sensor bestimmt sind, ist dem Fachmann ermöglicht, die Temperatur des Leistungshalbleiters und/oder des Kühlkörpers zu bestimmen aus der gemessenen Sensortemperatur, solange die Verlustleistung konstant gehalten wird. Dabei ist die Verzögerungszeit zu beachten.

Für die Praxis hat sich jedoch ein besonders einfaches Verfahren als erfolgreich herausgestellt. Bei diesem Verfahren wird die Steigung des zeitlichen Temperaturverlaufs der Temperatur des Sensors bestimmt. Der Modellwert für die Temperatur des Leistungshalbleiters wird dann als Summe der vom Sensor gemessenen Temperatur und der mit einem Korrekturfaktor multiplizierten Steigungswert gebildet. Dabei wird der Korrekturfaktor im Labor einmalig bestimmt und kann als Parameter im Umrichter hinterlegt werden. Auf diese Weise ist eine extrem einfache Weise gefunden für die Temperaturbestimmung des Leistungshalbleiters. Das Verfahren funktioniert besonders gut bei Anwendungen, bei welchen die Verlustleistung möglichst lange konstant ist, mindestens jedoch für die Dauer der Verzögerungszeit. Beispielsweise wird ein Förderband angeschaltet und mit einer ersten Geschwindigkeit vom Elektromotor angetrieben, wobei erst nach 10 oder 100 Minuten eine andere Geschwindigkeit eingestellt wird. Auch bei einem Hubwerk, das 5 Minuten nach oben fährt, 3 Minuten pausiert und dann wieder 3 Minuten nach unten fährt, ist die Temperaturbestimmung ausreichend gut.

Je höher allerdings die Wärmekapazitäten der verwendeten Komponenten des elektronischen Gerätes sind, desto ungenauer funktioniert die Temperaturbestimmung. Daher wird der Fachmann die Wärmekapazitäten und auch Entfernungen zwischen den Komponenten möglichst klein wählen, sofern dadurch nicht andere Eigenschaften des Gerätes verschlechtert werden.

Bei weiteren erfindungsgemäßen Ausführungsbeispielen wird statt eines einzigen Korrekturfaktors ein zu jedem Steigungswert zugehöriger Korrekturfaktor hinterlegt und verwendet.

Bei weiteren erfindungsgemäßen Ausführungsbeispielen wird statt eines einzigen Korrekturfaktors ein zu jedem Steigungswert und zu jeder Umgebungstemperatur zugehöriger Korrekturfaktor hinterlegt und verwendet bei der Temperaturbestimmung.

In den beiden letztgenannten Fällen sind höhere Genauigkeiten erreichbar.

Bei weiteren erfindungsgemäßen Ausführungsbeispielen werden statt der Steigung auch eine oder mehrere höhere zeitliche Ableitungen des zeitlichen Verlaufs der vom Sensor bestimmten Temperatur bestimmt und verwendet, wobei jeweils Korrekturfaktoren zugeordnet und im Speicher des Gerätes, beispielsweise Umrichter, hinterlegt werden.

### Bezugszeichenliste

1 Leiterplatte, insbesondere Multilayer-Leiterplatte
2 Befestigungsmittel zur lösbaren Verbindung
3 Wärmeleitpaste
4 Sensor
5 Anschluss-Füßchen
6 Kühlkörper
7 Isolierbereiche
8 Innenbahnen
9 Durchkontaktierungen
10 Bohrung
11 Trägermaterial
20 Bereiche für wärmeleitenden Kleber
40 Anschluss-Füßchen
41 Anschlussbahnen
42 Bohrloch
43 isolierender Bereich
44 metallischer Bereich
45 Innenlage
46 Innenbahnen
47 Teilbereich

## Patentansprüche

1. Vorrichtung,
umfassend eine mit einem Sensor (4) bestückte Leiterplatte (1) und einen Kühlkörper (6), wobei der Sensor (4) mit dem Kühlkörper (6) wärmeleitend verbunden ist,
wobei die Leiterplatte mit dem Kühlkörper verbunden ist,
**dadurch gekennzeichnet, dass**
die Leiterplatte (1) eine Multilayer-Leiterplatte ist (1),
dass metallische Bereiche (44) der Innenlagen (45) der Multilayer-Leiterplatte (1) elektrisch und thermisch verbunden sind mit mindestens einem metallischen Bereich (44) an der dem Kühlkörper (6) zugewandten Oberfläche,
dass die elektrischen Verbindungen Durchkontaktierungen (9) umfassen, insbesondere zur Herstellung eines homogenen Temperaturniveaus in den Innenlagen (45) der Leiterplatte (1),
dass der metallische Bereich (44) an der dem Kühlkörper (6) zugewandten Oberfläche mit dem Kühlkörper (6) elektrisch verbunden ist,
dass die Verbindung von Leiterplatte (1) und Kühlkörper (6) mittels eines Befestigungselementes (2) zur lösbaren Verbindung des Kühlkörpers (6) mit der Leiterplatte (1), insbesondere mit einer Schraube, erfolgt,
und dass das Befestigungsmittel (2) zur thermischen Verbindung des metallischen Bereichs (44) mit dem Kühlkörper (6) ausgebildet ist.

2. Vorrichtung nach Anspruch 1,
**dadurch gekennzeichnet, dass**
metallische Bereiche (44) eine höhere Wärmeleitfähigkeit als das Leiterplatten-Trägermaterial aufweisen, insbesondere zum Erreichen eines im Wesentlichen dem Kühlkörper (6) gleichenden Temperaturniveaus derjenigen Bereiche der Innenlagen (45), die räumlich dem Sensor (4) nahe sind, insbesondere deren Abstand zu den Berührungspunkten der Teile des Sensors (4) mit der Leiterplatte (1) kleiner als die Dicke der Leiterplatte (1) ist.

3. Vorrichtung nach einem der vorangegangenen Ansprüche,
**dadurch gekennzeichnet, dass**
Anschlusselemente (41) des Sensors (4) an der dem Kühlkörper (6) zugewandten Oberfläche mittels Lötverbindung elektrisch verbunden sind,
wobei mittels Durchkontaktierung (9) die Anschlusselemente (41) des Sensors (4) mit Leiterbahnen der dem Kühlkörper (6) abgewandten Oberflächen oder mit Innenbahnen (8, 46) der Leiterplatte (1) verbunden sind.

4. Vorrichtung nach einem der vorangegangenen Ansprüche,
**dadurch gekennzeichnet, dass**
die Lötverbindungen mittels SMD-Technik ausgeführt sind.

5. Vorrichtung nach einem der vorangegangenen Ansprüche,
**dadurch gekennzeichnet, dass**
- der Sensor (4) auf der dem Kühlkörper (6) abgewandten Seite der Leiterplatte (1) montiert und/oder
- dass der Sensor (4) auf der dem Kühlkörper (6) zugewandten Seite der Leiterplatte (1) montiert ist und/oder
- der Kühlkörper (6) Ausnehmungen aufweist, die Teile der mit dem Sensor (4) verbundenen Leiterplatte (1) umschließen.

6. Vorrichtung nach einem der vorangegangenen Ansprüche,
**dadurch gekennzeichnet, dass**
der Sensor (4) in einem Bereich der Leiterplatte (1) montiert ist, dessen räumlicher Abstand von der Berührungsfläche von Kühlkörper (6) und Leiterplatte (1) ein eins übersteigendes Vielfaches der Länge des Sensors (4) beträgt.

7. Vorrichtung nach einem der vorangegangenen Ansprüche,
**dadurch gekennzeichnet, dass**
Leiterplatte (1) und Sensor (4) zumindest stoffschlüssig verbunden sind, insbesondere wobei die Verbindung eine Klebeverbindung umfasst, insbesondere wobei die Klebeverbindung zwischen Leiterplatte (1) und Sensor (4) einen niedrigeren Wärmeübergangswiderstand aufweist als eine Verbindung des Sensors (4) mit der Leiterplatte (1) über Anschluss-Füßchen (40) des Sensors (4).

8. Vorrichtung nach einem der vorangegangenen Ansprüche,
**dadurch gekennzeichnet, dass**
die metallischen Bereiche (44) Kupfer umfassen oder aus Kupfer bestehen und/oder
die metallischen Bereiche (44) Leiterbahnen der Leiterplatte sind.

9. Vorrichtung nach einem der vorangegangenen Ansprüche,
**dadurch gekennzeichnet, dass**
der Kühlkörper (6) mit Kühlflächen von Leistungshalbleitern wärmeleitend verbunden ist und/oder dass
der Kühlköper (6) mit Kühlflächen von Leistungshalbleitern entweder mittelbar oder unmittelbar über mindestens eine Keramikplatte und/oder über Wärmeleitfolie wärmeleitend verbunden ist.

10. Vorrichtung nach einem der vorangegangenen Ansprüche,
**dadurch gekennzeichnet, dass**
der Kühlkörper
- Teil eines Gehäuses eines Verbrennungsmotors,
- und/oder Bestandteil einer Heizungsanlage,
- und/oder Bestandteil einer chemischen Anlage zur Durchführung chemischer Reaktionsprozesse,
- und/oder Bestandteil eines Kühlkreislaufs
ist.

11. Vorrichtung nach einem der vorangegangenen Ansprüche,
**dadurch gekennzeichnet, dass**
die Vorrichtung ein elektronisches Gerät ist, insbesondere ein Wechselrichter, Direktumrichter, Spannungszwischenkreisumrichter oder Umrichter zur Versorgung eines Elektromotors ist.

12. Elektronisches Gerät,
umfassend eine mit einem Sensor (4) in SMD-Technik bestückte Leiterplatte (1) und einen Kühlkörper (6),
wobei der Sensor (4) mit dem Kühlkörper (6) wärmeleitend verbunden ist,
wobei die Leiterplatte (1) mit dem Kühlkörper (6) verbunden ist,
**dadurch gekennzeichnet, dass**
die Leiterplatte (1) eine Multilayer-Leiterplatte (1) ist,
wobei Leiterbahnen in Innenlagen-Ebenen der Multilayer-Leiterplatte (1) elektrisch und thermisch verbunden sind mit mindestens einem metallischen Bereich (44) an der dem Kühlkörper (6) zugewandten Oberfläche der Multilayer-Leiterplatte (1),
wobei
die Leiterplatte (1) mit dem Kühlkörper (6) lösbar verbunden ist und
die Verbindung mittels eines Befestigungselementes (2) zur Verbindung des Kühlkörpers (6) mit der Leiterplatte (1) erfolgt,
wobei das Befestigungsmittel (2) zur thermischen Verbindung der Leiterbahnen in den Innenlagen-Ebenen mit dem Kühlkörper (6) ausgebildet ist.

13. Elektronisches Gerät nach Anspruch 12,
**dadurch gekennzeichnet, dass**
Anschlusselemente des Sensors (4) an der dem Kühlkörper (6) zugewandten Oberfläche der Multilayer-Leiterplatte (1) mittels Lötverbindung elektrisch verbunden sind, wobei mittels Durchkontaktierung (9) die Anschlusselemente des Sensors (4) mit Leiterbahnen der dem Kühlkörper (6) abgewandten Oberflächen der Multilayer-Leiterplatte (1) verbunden sind.

14. Elektronisches Gerät nach Anspruch 12,
**dadurch gekennzeichnet, dass**
Anschlusselemente des Sensors (4) an der dem Kühlkörper (6) abgewandten Oberfläche der Multilayer-Leiterplatte (1) mittels Lötverbindung elektrisch verbunden sind,
wobei sich die Auflagefläche des Kühlkörpers (6) nicht in diejenigen Bereiche erstreckt, die dem Sensor (4) auf der ihm abgewandten Seite der Multilayer-Leiterplatte (1) gegenüber liegen.

15. Verfahren zur Bestimmung der Temperatur einer Wärmequelle, insbesondere eines Leistungshalbleiters,
wobei die Wärmequelle mit einem Kühlkörper (6) wärmeleitend verbunden ist und der Sensor (4) mit dem Kühlkörper (6) wärmeleitend verbunden ist,
wobei eine Multilayer-Leiterplatte (1) mit dem Sensor (4) bestückt ist,
und wobei
- die Temperatur des Sensors (4) bestimmt wird,
- ein Maß für den Temperaturanstieg innerhalb einer Zeitspanne bestimmt wird,
- aus der Summe der Temperatur des Sensors (4) und dem mit einem zum Temperaturanstieg zugehörigen Korrekturfaktor multiplizierten Maß die Temperatur der Wärmequelle bestimmt wird.

16. Verfahren nach Anspruch 15,
**dadurch gekennzeichnet, dass**
das Maß für den Temperaturanstieg innerhalb einer Zeitspanne dadurch bestimmt wird, dass die Differenz der neuesten und der davor zuletzt gemessenen Temperatur des Sensors (4) bestimmt wird, wobei die Zeitspanne zwischen den Messungen der Temperatur des Sensors (4) stets gleich ist.

17. Verfahren nach Anspruch 15 oder 16,
**dadurch gekennzeichnet, dass**
das Maß für den Temperaturanstieg innerhalb einer Zeitspanne dadurch bestimmt wird, dass die Steigung des zeitlichen Verlaufs der Temperatur des Sensors (4) bestimmt wird, also die erste zeitliche Ableitung.

18. Verfahren nach einem der Ansprüche 15 bis 17,
**dadurch gekennzeichnet, dass**
statt des Korrekturfaktors eine Tabelle von Korrekturfaktoren verwendet wird, wobei jedem Steigungswert und/oder jedem Umgebungstemperatur-Wert und/oder anderen Größen ein Korrekturfaktor zugeordnet ist und entsprechend verwendet wird.

19. Verfahren nach einem der Ansprüche 15 bis 18,
**dadurch gekennzeichnet, dass**
von einem Umrichter die erfasste Temperatur zur Regelung bei der Versorgung eines Elektromotors verwendet und/oder aufgezeichnet wird.

20. Verfahren nach Anspruch 19,
**dadurch gekennzeichnet, dass**
bei Überschreitung eines vorgegebenen Grenzwerts der mit dem Sensor (4) erfassten Temperatur
- die Pulsweitenmodulationsfrequenz und/oder Leistungszufuhr des Umrichters reduziert,
- der Umrichter abgeschaltet
- und/oder ein Warnsignal an den Bediener der Anlage gesendet
wird.

21. Verwendung einer Innenlagen-Ebene und von Durchkontaktierungen (9) einer mit einem Sensor (4) in SMD-Technik bestückten und mit einem Kühlkörper (6) verbundenen Multilayer-Leiterplatte (1) zur wärmeleitenden Verbindung des Sensors (4) mit dem Kühlkörper (6) entlang der Innenlagen-Ebene und der Durchkontaktierungen (9),
wobei die Durchkontaktierungen (9) metallische Bereiche (44) der Innenlagen-Ebene elektrisch und thermisch verbinden mit mindestens einem metallischen Bereich (44) an der dem Kühlkörper (6) zugewandten Oberfläche der Multilayer-Leiterplatte (1),
der mit dem Kühlkörper (6) elektrisch und/oder zumindest wärmeleitend verbunden ist.

22. Verwendung nach Anspruch 21,
**dadurch gekennzeichnet, dass**
der Kühlkörper (6) mit einem Befestigungsmittel (2) mit der Leiterplatte (1) lösbar verbunden ist
und dass das Befestigungsmittel (2) zur Bewirkung der thermischen Anbindung zwischen Kühlkörper (6) und Innenlagen-Ebene verwendet wird.

## Claims

1. Device
comprising a circuit board (1) equipped with a sensor (4), and a cooling member (6), the sensor (4) being connected to the cooling member (6) in a heat-conducting manner, the circuit board being connected to the cooling member,
**characterised in that**
the circuit board (1) is a multilayer circuit board (1),
**in that** metal regions (44) of the internal layers (45) of the multilayer circuit board (1) are electrically and thermally connected to at least one metal region (44) on the surface facing the cooling member (6),
**in that** the electrical connections comprise vias (9), in particular for establishing a homogeneous temperature level in the internal layers (45) of the circuit board (1),
**in that** the metal region (44) on the surface facing the cooling member (6) is electrically connected to the cooling member (6),
**in that** the circuit board (1) and the cooling member (6) are connected by means of a fastening element (2) for releasably connecting the cooling member (6) to the circuit board (1), in particular by a screw,
and **in that** the fastening means (2) is designed to thermally connect the metal region (44) to the cooling member (6).

2. Device according to claim 1,
**characterised in that**
metal regions (44) have a higher thermal conductivity than the circuit board substrate material, in particular to achieve substantially the same temperature level as the cooling member (6) in those regions of the internal layers (45) that are spatially close to the sensor (4), in particular those whose distance from the points at which the parts of the sensor (4) contact the circuit board (1) is less than the thickness of the circuit board (1).

3. Device according to any of the preceding claims,
**characterised in that**
connection elements (41) of the sensor (4) on the surface facing the cooling member (6) are electrically connected by means of soldered connections,
the connection elements (41) of the sensor (4) being connected by means of vias (9) to conducting tracks of the surfaces facing away from the cooling member (6) or to internal tracks (8, 46) of the circuit board (1).

4. Device according to any of the preceding claims,
**characterised in that**
the soldered connections are implemented by means of SMD technology.

5. Device according to any of the preceding claims,
**characterised in that**
- the sensor (4) is mounted on the side of the circuit board (1) facing away from the cooling member (6) and/or
- **in that** the sensor (4) is mounted on the side of the circuit board (1) facing the cooling member (6) and/or
- the cooling member (6) comprises recesses that enclose parts of the circuit board (1) that is connected to the sensor (4).

6. Device according to any of the preceding claims,
**characterised in that**
the sensor (4) is mounted in a region of the circuit board (1) whose spatial distance from the contact surface between the cooling member (6) and the circuit board (1) is a multiple, greater than one, of the length of the sensor (4).

7. Device according to any of the preceding claims,
**characterised in that**
the circuit board (1) and the sensor (4) are at least integrally bonded, the connection in particular comprising an adhesive connection, the adhesive connection between the circuit board (1) and the sensor (4) in particular having a lower heat transfer resistance than a connection of the sensor (4) to the circuit board (1) via connection tabs (40) of the sensor (4).

8. Device according to any of the preceding claims,
**characterised in that**
the metal regions (44) comprise or consist of copper and/or
the metal regions (44) are conducting tracks of the circuit board.

9. Device according to any of the preceding claims,
**characterised in that**
the cooling member (6) is connected to cooling surfaces of power semiconductors in a heat-conducting manner and/or **in that**
the cooling member (6) is connected in a heat-conducting manner to cooling surfaces of power semiconductors either directly or indirectly by means of at least one ceramic plate and/or by means of heat-conducting foil.

10. Device according to any of the preceding claims,
**characterised in that**
the cooling member is
- part of a housing of an internal combustion engine,
- and/or a component of a heating system,
- and/or a component of a chemical system for carrying out chemical reaction processes,
- and/or a component of a cooling circuit.

11. Device according to any of the preceding claims,
**characterised in that**
the device is an electronic instrument, in particular an inverter, a direct converter, a voltage source inverter or a converter for powering an electric motor.

12. Electronic instrument
comprising a circuit board (1) equipped with a sensor (4) in SMD technology, and a cooling member (6),
the sensor (4) being connected to the cooling member (6) in a heat-conducting manner,
the circuit board (1) being connected to the cooling member (6),
**characterised in that**
the circuit board (1) is a multilayer circuit board (1),
conducting tracks in internal layer planes of the multilayer circuit board (1) being electrically and thermally connected to at least one metal region (44) on the surface of the multilayer circuit board (1) facing the cooling member (6),
the circuit board (1) being releasably connected to the cooling member (6) and
the connection being made by means of a fastening element (2) for connecting the cooling member (6) to the circuit board (1),
the fastening means (2) being designed to thermally connect the conducting tracks in the internal layer planes to the cooling member (6).

13. Electronic instrument according to claim 12,
**characterised in that**
connection elements of the sensor (4) on the surface of the multilayer circuit board (1) facing the cooling member (6) are electrically connected by means of soldered connections, the connection elements of the sensor (4) being connected by means of vias (9) to conducting tracks of the surfaces of the multilayer circuit board (1) facing away from the cooling member (6).

14. Electronic instrument according to claim 12,
**characterised in that**
connection elements of the sensor (4) on the surface of the multilayer circuit board (1) facing away from the cooling member (6) are electrically connected by means of soldered connections,
the bearing surface of the cooling member (6) not extending in the regions that are opposite the sensor (4) on the side of the multilayer circuit board (1) facing away from said sensor.

15. Method for determining the temperature of a heat source, in particular of a power semiconductor,
wherein the heat source is connected to a cooling member (6) in a heat-conducting manner and the sensor (4) is connected to the cooling member (6) in a heat-conducting manner, wherein a multilayer circuit board (1) is equipped with the sensor (4),
and wherein
- the temperature of the sensor (4) is determined,
- a measure for the temperature increase within a time period is determined,
- the temperature of the heat source is determined from the total of the temperature of the sensor (4) and the measure multiplied by a correction factor associated with the temperature increase.

16. Method according to claim 15,
**characterised in that**
the measure for the temperature increase within a time period is determined by determining the difference between the latest and the closest previously measured temperature of the sensor (4), the time period between the measurements of the temperature of the sensor (4) always being the same.

17. Method according to either claim 15 or claim 16,
**characterised in that**
the measure for the temperature increase within a time period is determined by determining the gradient of the curve over time of the temperature of the sensor (4), i.e. the first time derivative.

18. Method according to any of claims 15 to 17,
**characterised in that**
a table of correction factors is used instead of the correction factor, a correction factor being assigned to each gradient value and/or to each ambient temperature value and/or to other variables and being used accordingly.

19. Method according to any of claims 15 to 18,
**characterised in that**
a converter uses and/or records the detected temperature for control purposes when supplying power to an electric motor.

20. Method according to claim 19,
**characterised in that**
if a predefined threshold for the temperature detected by the sensor (4) is exceeded
- the pulse-width-modulation frequency and/or the power supply of the converter is reduced,
- the converter is switched off,
- and/or a warning signal is sent to the system operator.

21. Use of an internal layer plane and of vias (9) of a multilayer circuit board (1) that is equipped with a sensor (4) in SMD technology and connected to a cooling member (6), for connecting the sensor (4) to the cooling member (6) in a heat-conducting manner along the internal layer plane and the vias (9),
wherein the vias (9) electrically and thermally connect metal regions (44) of the internal layer plane to at least one metal region (44) on the surface of the multilayer circuit board (1) facing the cooling member (6), said region being connected to the cooling member (6) electrically and/or at least in a heat-conducting manner.

22. Use according to claim 21,
**characterised in that**
the cooling member (6) is releasably connected to the circuit board (1) by a fastening means (2),
and **in that** the fastening means (2) is used to bring about the thermal link between the cooling member (6) and the internal layer plane.

## Revendications

1. Dispositif
comprenant une plaquette imprimée (1) équipée d'un capteur (4), et un corps de refroidissement (6),
ledit capteur (4) étant en liaison thermiquement conductrice avec ledit corps de refroidissement (6),
ladite plaquette imprimée étant raccordée audit corps de refroidissement,
**caractérisé par le fait que**
la plaquette imprimée (1) est une plaquette imprimée (1) à couches multiples ;
**par le fait que** des zones métalliques (44) des couches intérieures (45) de ladite plaquette imprimée (1) à couches multiples sont reliées électriquement et thermiquement, avec au moins une zone métallique (44) sur la surface pointant vers le corps de refroidissement (6) ;
**par le fait que** les raccordements électriques incluent des connexions transversales (9), notamment en vue d'instaurer un niveau de température homogène dans lesdites couches intérieures (45) de la plaquette imprimée (1) ;
**par le fait que** la zone métallique (44), située sur ladite surface pointant vers le corps de refroidissement (6), est raccordée électriquement audit corps de refroidissement (6) ;
**par le fait que** la liaison de la plaquette imprimée (1) et du corps de refroidissement (6) est établie au moyen d'un élément de fixation (2), en particulier à l'aide d'une vis, en vue de la liaison libérable dudit corps de refroidissement (6) avec ladite plaquette imprimée (1) ; et **par le fait que** le moyen de fixation (2) est réalisé en vue de la liaison thermique de ladite zone métallique (44) avec ledit corps de refroidissement (6).

2. Dispositif selon la revendication 1,
**caractérisé par le fait que**
des zones métalliques (44) présentent une conductivité thermique supérieure à celle du matériau du substrat de la plaquette imprimée, notamment en vue d'obtenir un niveau de température équivalant, pour l'essentiel, à celui du corps de refroidissement (6) dans les régions des couches intérieures (45) qui sont spatialement proches du capteur (4) et dont la distance, par rapport aux points auxquels des parties dudit capteur (4) sont en contact avec la plaquette imprimée (1), est notamment moindre que l'épaisseur de ladite plaquette imprimée (1).

3. Dispositif selon l'une des revendications précédentes,
**caractérisé par le fait que**
des éléments de raccordement (41) du capteur (4) sont connectés électriquement, au moyen d'une jonction brasée, sur la surface pointant vers le corps de refroidissement (6), sachant que lesdits éléments de raccordement (41) du capteur (4) sont reliés, par connexion transversale (9), à des pistes conductrices des surfaces tournées à l'opposé dudit corps de refroidissement (6) ou à des pistes intérieures (8, 46) de la plaquette imprimée (1).

4. Dispositif selon l'une des revendications précédentes,
**caractérisé par le fait que**
les jonctions brasées sont exécutées par technologie SMD.

5. Dispositif selon l'une des revendications précédentes,
**caractérisé par le fait que**
- le capteur (4) est monté du côté de la plaquette imprimée (1) qui est tourné à l'opposé du corps de refroidissement (6) ; et/ou
- **par le fait que** ledit capteur (4) est monté du côté de ladite plaquette imprimée (1) qui pointe vers ledit corps de refroidissement (6), et/ou
- que ledit corps de refroidissement (6) est muni d'évidements ceinturant des parties de ladite plaquette imprimée (1) qui sont raccordées audit capteur (4).

6. Dispositif selon l'une des revendications précédentes,
**caractérisé par le fait que**
le capteur (4) est monté dans une région de la plaquette imprimée (1) dont la distance spatiale, par rapport à la surface de contact entre le corps de refroidissement (6) et ladite plaquette imprimée (1), représente un multiple de la longueur dudit capteur (4), lequel multiple est supérieur à un.

7. Dispositif selon l'une des revendications précédentes,
**caractérisé par le fait que**
la plaquette imprimée (1) et le capteur (4) sont au moins reliés par solidarisation matérielle, la liaison incluant notamment une liaison collée, sachant en particulier que la liaison collée, entre ladite plaquette imprimée (1) et ledit capteur (4), présente une résistance de transfert thermique inférieure à celle d'une liaison, entre le capteur (4) et la plaquette imprimée (1), établie par l'intermédiaire de pattes de connexion (40) dudit capteur (4).

8. Dispositif selon l'une des revendications précédentes,
**caractérisé par le fait que**
les zones métalliques (44) renferment du cuivre, ou sont constituées de cuivre,
et/ou
lesdites zones métalliques (44) sont des pistes conductrices de la plaquette imprimée.

9. Dispositif selon l'une des revendications précédentes,
**caractérisé par le fait que**
le corps de refroidissement (6) est en liaison thermiquement conductrice avec des surfaces de refroidissement de semi-conducteurs de puissance ;
et/ou **par le fait que**
ledit corps de refroidissement (6) est en liaison thermiquement conductrice, avec des surfaces de refroidissement de semi-conducteurs de puissance, soit indirectement, soit directement par l'intermédiaire d'au moins une platine en céramique et/ou par l'intermédiaire d'un film thermoconducteur.

10. Dispositif selon l'une des revendications précédentes,
**caractérisé par le fait que**
le corps de refroidissement
- constitue une partie du carter d'un moteur à combustion interne
- et/ou fait partie intégrante d'une installation de chauffage
- et/ou fait partie intégrante d'une installation chimique dévolue à la conduite de processus de réaction chimique
- et/ou fait partie intégrante d'un circuit de refroidissement.

11. Dispositif selon l'une des revendications précédentes,
**caractérisé par le fait que**
ledit dispositif est un appareil électronique, en particulier un inverseur, un convertisseur direct, un convertisseur à circuit intermédiaire de tension ou un onduleur, dédié à l'alimentation d'un moteur électrique.

12. Appareil électronique
comprenant une plaquette imprimée (1) équipée d'un capteur (4) par technologie SMD, et un corps de refroidissement (6),
ledit capteur (4) étant en liaison thermiquement conductrice avec ledit corps de refroidissement (6),
ladite plaquette imprimée (1) étant raccordée audit corps de refroidissement (6),
**caractérisé par le fait que**
la plaquette imprimée (1) est une plaquette imprimée (1) à couches multiples,
des pistes conductrices étant reliées électriquement et thermiquement dans des plans de couches intérieures de ladite plaquette imprimée (1) à couches multiples, avec au moins une zone métallique (44) sur la surface de ladite plaquette imprimée (1) à couches multiples qui pointe vers le corps de refroidissement (6),
sachant que
ladite plaquette imprimée (1) est raccordée de manière libérable audit corps de refroidissement (6), et que
la liaison est établie au moyen d'un élément de fixation (2), en vue de relier ledit corps de refroidissement (6) à ladite plaquette imprimée (1),
le moyen de fixation (2) étant réalisé en vue de la liaison thermique desdites pistes conductrices avec ledit corps de refroidissement (6) dans lesdits plans de couches intérieures.

13. Appareil électronique selon la revendication 12,
**caractérisé par le fait que**
des éléments de raccordement du capteur (4) sont connectés électriquement, au moyen d'une jonction brasée, sur la surface de la platine imprimée (1) à couches multiples qui pointe vers le corps de refroidissement (6), lesdits éléments de raccordement du capteur (4) étant reliés, par connexion transversale (9), à des pistes conductrices des surfaces de ladite platine imprimée (1) à couches multiples qui sont tournées à l'opposé dudit corps de refroidissement (6).

14. Appareil électronique selon la revendication 12,
**caractérisé par le fait que**
des éléments de raccordement du capteur (4) sont connectés électriquement, au moyen d'une jonction brasée, sur la surface de la platine imprimée (1) à couches multiples qui est tournée à l'opposé du corps de refroidissement (6),
sachant que la surface d'appui dudit corps de refroidissement (6) ne s'étend pas jusque dans les régions faisant face au capteur (4) du côté de ladite plaquette imprimée (1) à couches multiples qui est tourné à l'opposé dudit capteur.

15. Procédé de détermination de la température d'une source de chaleur, en particulier d'un semi-conducteur de puissance,
dans lequel ladite source de chaleur est en liaison thermiquement conductrice avec un corps de refroidissement (6), et le capteur (4) est en liaison thermiquement conductrice avec ledit corps de refroidissement (6),
une platine imprimée (1) à couches multiples étant équipée dudit capteur (4),
et dans lequel
- la température du capteur (4) est déterminée,
- un critère estimatif, relatif à l'accroissement de température, est déterminé à l'intérieur d'un laps de temps,
- la température de la source de chaleur est déterminée sur la base de la somme de ladite température du capteur (4) et dudit critère estimatif multiplié par un facteur de correction associé audit accroissement de température.

16. Procédé selon la revendication 15,
**caractérisé par le fait que**
le critère estimatif affecté à l'accroissement de température est déterminé, à l'intérieur d'un laps de temps, par détermination de la différence entre la température du capteur (4) la plus récemment mesurée et celle mesurée précédemment en dernier lieu, le laps de temps, qui sépare les mesures de ladite température du capteur (4), étant en permanence identique.

17. Procédé selon la revendication 15 ou 16,
**caractérisé par le fait que**
le critère estimatif affecté à l'accroissement de température est déterminé, à l'intérieur d'un laps de temps, par détermination de la pente du profil temporel de la température du capteur (4), c'est-à-dire de la dérivée première dans le temps.

18. Procédé selon l'une des revendications 15 à 17,
**caractérisé par le fait**
**qu'**un tableau de facteurs de correction est utilisé à la place du facteur de correction, sachant qu'un facteur de correction est affecté à chaque valeur de pente et/ou à chaque valeur de température ambiante et/ou à d'autres grandeurs et est utilisé de manière correspondante.

19. Procédé selon l'une des revendications 15 à 18,
**caractérisé par le fait que**
la température détectée est utilisée et/ou affichée, par un onduleur, en vue de la régulation lors de l'alimentation d'un moteur électrique.

20. Procédé selon la revendication 19,
**caractérisé par le fait que**,
dans le cas d'un dépassement d'une valeur limite préétablie de la température détectée par le capteur (4),
- la fréquence de modulation des largeurs d'impulsions, et/ou la fourniture de puissance de l'onduleur, est (sont) réduite(s),
- ledit onduleur est mis hors fonction
- et/ou un signal d'alerte est délivré à l'utilisateur de l'installation.

21. Utilisation d'un plan de couches intérieures et de connexions transversales (9) d'une plaquette imprimée (1) à couches multiples, équipée d'un capteur (4) par technologie SMD et raccordée à un corps de refroidissement (6), en vue de la liaison thermiquement conductrice dudit capteur (4) avec ledit corps de refroidissement (6) le long dudit plan de couches intérieures et desdites connexions transversales (9), lesquelles connexions transversales (9) relient électriquement et thermiquement des zones métalliques (44) dudit plan de couches intérieures, avec au moins une zone métallique (44) qui, située sur la surface de ladite plaquette imprimée (1) à couches multiples pointant vers ledit le corps de refroidissement (6),
est en liaison électrique et/ou au moins thermiquement conductrice avec ledit corps de refroidissement (6).

22. Utilisation selon la revendication 21,
**caractérisée par le fait que**
le corps de refroidissement (6) est relié de manière libérable à la plaquette imprimée (1), à l'aide d'un moyen de fixation (2) ;
et **par le fait que** ledit moyen de fixation (2) est utilisé pour provoquer la liaison thermique entre ledit corps de refroidissement (6) et le plan de couches intérieures.
